# EUROPÄISCHE PATENTSCHRIFT

(11) **EP 2 229 688 B1**
(45) Veröffentlichungstag und Bekanntmachung des Hinweises auf die Patenterteilung: **21.09.2011**
(21) Anmeldenummer: 09777346.9
(22) Anmeldetag: 21.07.2009
(51) Int. Cl.: H01L 21/00, H01L 21/60, C25D 7/12, C25D 17/02

(54) **VORRICHTUNG UND VERFAHREN ZUR NASSBEHANDLUNG VON UNTERSCHIEDLICHEN SUBSTRATEN**
DEVICE AND METHOD FOR THE WET PROCESSING OF DIFFERENT SUBSTRATES
PROCÉDÉ ET DISPOSITIF DE TRAITEMENT PAR VOIE HUMIDE DE DIFFÉRENTS SUBSTRATS

(30) Priorität: 01.09.2008 DE 102008045256
(43) Veröffentlichungstag der Anmeldung: 22.09.2010
(73) Patentinhaber: RENA GmbH, 78148 Gütenbach (DE)
(72) Erfinder: REUSTLE, Peter, 74399 Walheim (DE); GUTEKUNST, Mathias, 72221 Haiterbach (DE)
(74) Vertreter: Stürken, Joachim
(86) Internationale Anmeldenummer: PCT/EP2009/005299
(87) Internationale Veröffentlichungsnummer: WO 2010/022824

(56) Entgegenhaltungen:
- WO-A1-02/33152
- WO-A1-99/24647
- US-A1- 2002 079 215
- US-A1- 2008 048 306
- US-A1- 2008 105 555

## Beschreibung

Die Erfindung betrifft Prozesskammern zur Behandlung von Substraten, z. B. als Wafer, Solarzellen oder Hybride, nachfolgend auch als Gut bezeichnet. Behandlungsprozesse sind z. B. das Reinigen, Texturieren, Dopen, Beschichten, Ätzen sowie das Spülen. Die Erfindung eignet sich auch zum elektrochemischen Metallisieren und Entmetallisieren.

Das flache Gut wird nur an einer Seite und/oder an seinem umlaufenden Rand nass behandelt. Die Unterseite ist im allgemeinen die zu behandelnde Seite des Gutes. Sie wird über der oben offenen Prozesskammer so positioniert, dass sie von der Behandlungsflüssigkeit bzw. vom Elektrolyten erreicht und damit benetzt wird. Diese Prozesskammern sind z. B. unter den Bezeichnungen Cup, Tank, Reaktionsbehälter, Fountain Cup u. a. bekannt.

Eine derartige typische Prozesskammer beschreibt die Druckschrift US 4 906 341 mit der Bezeichnung "Plating Tank". In diesem Falle wird das Gut einseitig galvanisiert. Es wird an der Unterseite mittels eines Gleichrichters und über untere elektrische Kontakte kathodisch polarisiert. Die Größe der oberen Öffnung der Prozesskammer und die Anordnung der Kontakte sind für ein bestimmtes Gut mit gleichbleibenden Abmessungen dimensioniert. Güter mit anderen Abmessungen sind in der Prozesskammer gemäß dieser Erfindung nicht behandelbar.

Als Anode ist eine unlösliche Gitterelektrode vorgesehen. Sie erlaubt das Durchströmen des im Kreislauf durch die Prozesskammer geförderten Elektrolyten. Derartige unlösliche Anoden können in der Prozesskammer fest eingebaut sein. Sie erfordern keine Ergänzung von metallischem Anodenmaterial in der Prozesskammer. Jedoch muss dafür gesorgt werden, dass die erforderliche Konzentration der Metallionen im umlaufend geförderten Elektrolyten durch geeignete Ergänzungen konstant erhalten wird. In der Praxis ist dies aufwändiger als die Verwendung von löslichen Anoden. Lösliche Anoden erfordern jedoch in regelmäßigen Abständen ein Ergänzen derselben in der Prozesskammer, d. h. Wartungsaufwand mit längeren Produktionsunterbrechungen. Nicht zuletzt wegen der erforderlichen elektrischen Kontaktierung der Anoden sind diese Wartungsarbeiten mit Handarbeit verbunden.

Eine weitere typische Prozesskammer mit der Bezeichnung "Cup Plating Apparatus" wird in der Druckschrift US 5 000 827 beschrieben. Die aus einem Behälter bestehende Prozesskammer ist oben offen. Diese Öffnung, d. h. ihr Durchmesser ist relativ zum Durchmesser des Gutes optimiert, das hier ein Wafer ist. Der Wafer wird über der oberen Öffnung so positioniert, dass dessen kathodisch gepolte Unterseite vom strömenden Elektrolyt benetzt wird. Als Anode wird eine unlösliche Anode verwendet. Diese Prozesskammer, deren Abmessungen, insbesondere die obere Öffnung, optimal an die Abmessungen des Gutes angepasst sind, eignet sich daher nur zur Behandlung von Gut mit einer ganz bestimmter Abmessung, mindestens bezüglich seines Durchmessers.

In der Druckschrift US 5 391 285 wird eine Prozesskammer zum Galvanisieren von Gut beschrieben, die zur Beeinflussung der Schichtdickenverteilung in der axialen Länge einstellbar ist. Hierzu ist ein Teil der Prozesskammer gegen den anderen Teil axial verschiebbar ausgeführt. Damit kann eine optimale Länge der Prozesskammer bezüglich der Schichtdickenverteilung auf dem Gut eingestellt werden. Der Durchmesser der oberen öffnung der Prozesskammer bleibt dabei konstant. Von daher eignet sich auch diese Prozesskammer nur zur Behandlung von flachem Gut mit einem bestimmten Durchmesser.

In der Druckschrift DE 10 2007 020 449 A1 wird eine Prozesskammer, insbesondere zur einseitigen Nassbehandlung und/oder zum einseitigen Galvanisieren von Solarzellen beschrieben. In diesem Falle hat die Prozesskammer entsprechend der Form der Solarzelle eine rechteckige oder quadratische obere Öffnung. Diese ist mit ihrem Abmessungen an die Abmessungen des Gutes angepasst. Weil die Abmessungen bzw. die Nennmaße von Solarzellen in der Praxis größeren Sprüngen unterliegen, z. B. 125 x 125 mm² und 156 x 156 mm², eignet sich auch diese Prozesskammer nur zur Nassbehandlung von Gut mit einer bestimmten äußeren Abmessung, d. h. für einen Typ bzw. für ein Nennmaß der Solarzelle. Hinzu kommt, dass auch die an der Unterseite insbesondere elektrolytisch zu behandelnden Strukturen stets das gleiche Layout mindestens an den Stellen aufweisen muss, an denen das Gut oberhalb der oberen Öffnung auf Gutauflagen der Prozesskammer aufgelegt und elektrisch kontaktiert wird. Die Gutauflagen sind fest mit den Wänden der Prozesskammer verbunden. Sie können in ihrer Lage nicht verändert werden. Dies bedeutet, dass selbst Güter mit gleichen Nennmaßen, jedoch mit unterschiedlichen zu behandelnden Strukturen bzw. Layouts in der Prozesskammer gemäß der Druckschrift DE 10 2007 020 449 A1 nicht behandelt werden können.

Gemeinsamer Nachteil aller Prozesskammern nach dem Stand der Technik ist die nicht vorhandene Flexibilität in Bezug auf unterschiedliche zu behandelnde Güter. Insbesondere bei elektrolytischen Behandlungen ist neben gleichen Nennmaßen meist auch eine einheitliche Struktur bzw. Lage der Kontaktierungspunkte auf der Prozessseite des Gutes erforderlich. Unterschiedliche Layouts des Gutes im Bereich der Gutauflagen sind wegen deren festen Anordnung nicht behandelbar, auch wenn gleich große Nennmaße des Gutes vorliegen.

Aufgabe der Erfindung ist es, eine Prozesskammer zu beschreiben, die es ermöglicht, dass insbesondere in einer automatisierten Produktionsanlage nacheinander Güter mit unterschiedlichen Nennmaßen und/oder mit unterschiedlichen Strukturen mindestens im Bereich der Gutauflagen nass behandelt werden kann, wobei bei einem galvanischen Prozess auch die Wartungsarbeiten an den löslichen Anoden in die Automatisierung einbezogen werden sollen.

Gelöst wird diese Aufgabe durch die Vorrichtung gemäß Patentanspruch 1 und durch des Verfahren nach Patentanspruch 9. Die Unteransprüche beschreiben vorteilhafte Ausführungen der Erfindung.

Gemäß der Erfindung ist die Prozesskammer modular aufgebaut. Sie besteht mindestens aus einem Unterteil und einem Oberteil, wobei beide Teile in der Produktionsanlage, d. h. vor Ort trennbar miteinander verbunden sind. Eine Produktionsanlage zur Nassbehandlung von Gut bzw. zur elektrolytischen Behandlung beinhaltet in der Regel mehrere verschiedene Prozesse. Jeweils für einen Prozess gibt es zahlreiche Prozesskammern. Transportmittel fördern das Gut von Prozesskammer zu Prozesskammer, d. h. von Prozess zu Prozess.

In einer derartigen Anlage sind die erfindungsgemäßen Unterteile der Prozesskammern fest installiert. In der Regel wird von unten im Zentrum dieser Prozesskammer bzw. des Unterteiles die Behandlungsflüssigkeit eingeleitet. Hierzu dient z. B. jeweils ein axial angeordnetes Einlassrohr. Des Weiteren können im Unterteil u. a. Strömungselemente angeordnet sein. Diese dienen z. B. zur Erzeugung einer laminaren Strömung der Behandlungsflüssigkeit an der zu behandelnden Unterseite des Gutes. Die Strömungselemente können auch so gestaltet sein, dass in der gesamten Prozesskammer eine besonders turbulente Bewegung der Behandlungsflüssigkeit auftritt.

Bei einem Galvanisierprozess wird zusätzlich zu den Strömungselementen oder ausschließlich im Unterteil der Prozesskammer die erforderliche lösliche oder unlösliche Anode angeordnet. Die unlösliche Anode besteht z. B. aus einem Streckmetallgitter aus Titan mit einer Oberflächenbeschichtung aus Platin oder Iridiumoxid. Strömungselemente und/oder unlösliche Anoden können fest im Unterteil befestigt sein, weil sie keine fortwährenden Wartungsarbeiten erfordern. Eine lösliche Anode kann im Unterteil als Plattenanode so gestaltet sein, dass der Elektrolytkreislauf nicht nachteilig behindert wird. Bevorzugt erhält diese Plattenanode z. B. am Rand exponierte Stellen zu ihrer Ergreifung mittels eines Greifers. Der Greifer kann sich an einem Handhabungsgerät oder an einem Roboterarm der Produktionsanlage befinden, die auch als Transportmittel dienen können. Der erfindungsgemäß mögliche automatische Tausch der Anoden wird weiter unten beschrieben.

Bei Verwendung von löslichen Anoden als Schüttgut ist bevorzugt ein Anodenkorb vorgesehen, der das Anodenmaterial z. B. als Kugeln oder Abschnitte aufnimmt. Dieser Anodenkorb, der im Unterteil der Prozesskammer platziert ist, kann aus Metall, z. B. aus Titanstreckmetall oder aus Kunststoff bestehen. Bei einer Kunststoffausführung ist das Schüttgut z. B. mittels einer eingelegten Kontaktschleife elektrische zu kontaktieren. Diese Anodenkörbe sind so gestaltet, dass auch hier der Elektrolyt am Durchströmen der Prozesskammer nicht nachteilig behindert wird. An den Anodenkörben befinden sich wieder exponierte Stellen als Anodengriffe zum Ergreifen und Ausheben aus den Unterteilen bevorzugt mittels eines automatisierten Greifers oder durch einen manuellen Eingriff.

Die erfindungsgemäße mindestens Zweiteilung der Prozesskammer erlaubt es, die oben beschriebenen Aggregate wie Einlassrohr, Strömungsmittel, Anoden u. a. im fest in der Anlage installierten Unterteil zu platzieren. Aus konstruktiven Gründen kann es in Ausnahmefällen sinnvoll sein die Prozesskammer in mehr als zwei Teile formschlüssig und trennbar zu gestalten. In diesem Falle besteht das Oberteil und/oder das Unterteil aus entsprechend zwei oder mehr manuell oder automatisch trennbaren Konstruktionseinheiten.

Erfindungsgemäß ist das Oberteil mit der Größe seiner oberen Öffnung an die Abmessungen des zu behandelnden Gutes angepasst. Zur Behandlung von Gütern verschiedener Nennmaße werden erfindungsgemäß die Oberteile der Prozesskammern ausgetauscht. Die Anzahl der unterschiedlich großen Nennmaße von Gütern entspricht der Anzahl der verschieden großen, an der Anlage verfügbaren Oberteile. Die Anzahl der Oberteile einer Abmessung, die für eine Produktionsanlage verfügbar sind, wird vorteilhaft so groß gewählt, dass damit alle installierten Unterteile zur vollständigen Prozesskammer ergänzt werden können. Die mindestens eine erfindungsgemäße Trennstelle von Unterteil und Oberteil(en) ist so gestaltet, dass beide Teile nach dem Zusammenfügen axial mit geringer Toleranz in einer Flucht liegen und dass dabei durch möglicherweise auftretende Undichtigkeiten möglichst wenig oder keine Behandlungsflüssigkeit an dieser Stelle aus der Prozesskammer in einen Auffangbehälter ausläuft. Des Weiteren ist die Trennstelle vorzugsweise zum automatischen Austausch des Oberteiles mittels eines Greifers, z. B. am Handhabungsgerät oder an einem Roboterarm gestaltet. Bevorzugt werden beide Teile, d. h. Unterteil und Oberteil axial einrastend ineinander geschoben oder zentriert aufeinander gestellt mit Rasten, die die Endposition gegen zufälliges Verschieben bzw. auseinanderdriften sichern. An den Oberteilen befinden sich für den Transport Greifstellen als Behältergriffe, zum automatischen oder manuellen Zusammenfügen und zum Trennen der mindestens zwei Teile der Prozesskammer. Somit ist die Anpassung der Anlage zur Behandlung von Gut mit unterschiedlichen Abmessungen automatisch möglich.

Sehr vorteilhaft ist die Erfindung auch dann, wenn Gut mit gleichen Nennmaßen, jedoch mit unterschiedlichen Strukturen an der Behandlungsseite zu prozessieren ist. Die Strukturen, z. B. bei Solarzelle bestimmen die Orte der Gutauflagen. Diese können sich in Abhängigkeit des Produktes an unterschiedlichen Stellen befinden, 1 auch wenn gleich große äußere Abmessungen des Gutes vorliegen. Entsprechend unterschiedlich sind auch die Gutauflagen an der oberen Öffnung der Prozesskammer anzuordnen, d. h. zu fixieren. Dies wird nach einer bevorzugten Ausführungsform durch entsprechend ausgestattete Oberteile realisiert, d. h. sie sind mit den jeweils erforderlichen und platzierten Gutauflagen ausgerüstet.

Ein weiterer Vorteil der Erfindung besteht bei elektrochemischen Prozessen, insbesondere beim Galvanisieren. Bei löslichen Anoden ist regelmäßig eine Anodenwartung durchzuführen. Diese erforderlichen Wartungsarbeiten werden durch die Zweiteilung der erfindungsgemäßen Prozesskammer, insbesondere bei unterschiedlich großem Gut, wesentlich unterstützt. Auch bei einer kleinen oberen Öffnung für ein kleines Gut ist durch die Zweiteilung der Prozesskammer ein automatisches Austauschen bzw. vertikales Herausnehmen der im Durchmesser größeren löslichen Anoden zu Wartungszwecken möglich. Die zur kathodischen Polarisierung des Gutes erforderlichen elektrischen Kontakte ragen in der Regel radial in die obere Öffnung hinein, wodurch die manuelle Anodenwartung erschwert wird und eine automatische Anodenwartung unmöglich ist. Durch diese Öffnung muss die Anode gewartet bzw. ausgehoben werden. Der manueller Anodentausch, der wegen der damit verbundenen Kosten jedoch unerwünscht ist, wird durch die Kontakte behindert. Nach einer bevorzugten Ausführungsform wird dieser Nachteil durch die Möglichkeit, das Oberteil zusammen mit eventuell vorhandenen elektrische Kontakten automatisch vom Unterteil völlig zu entfernen, behoben. Dies auch sehr vorteilhaft für unterschiedlich großes Gut. Somit erlaubt die Erfindung in einer Anlage die Produktion von Gut mit unterschiedlichen Nennmaßen sowie die Unterstützung von Wartungsarbeiten bei elektrolytischen Prozessen mit löslichen Anoden jeweils durch eine diesbezügliche Automatisierung der hierzu erforderlichen Handhabungen.

Insgesamt erweist sich die erfindungsgemäße Prozesskammer als eine sehr flexible und wirtschaftliche Lösung zur Produktion von unterschiedlichen Gütern in einer einzigen Produktionsanlage. Diese Flexibilität ist nach dem Stand der Technik nicht erreichbar.

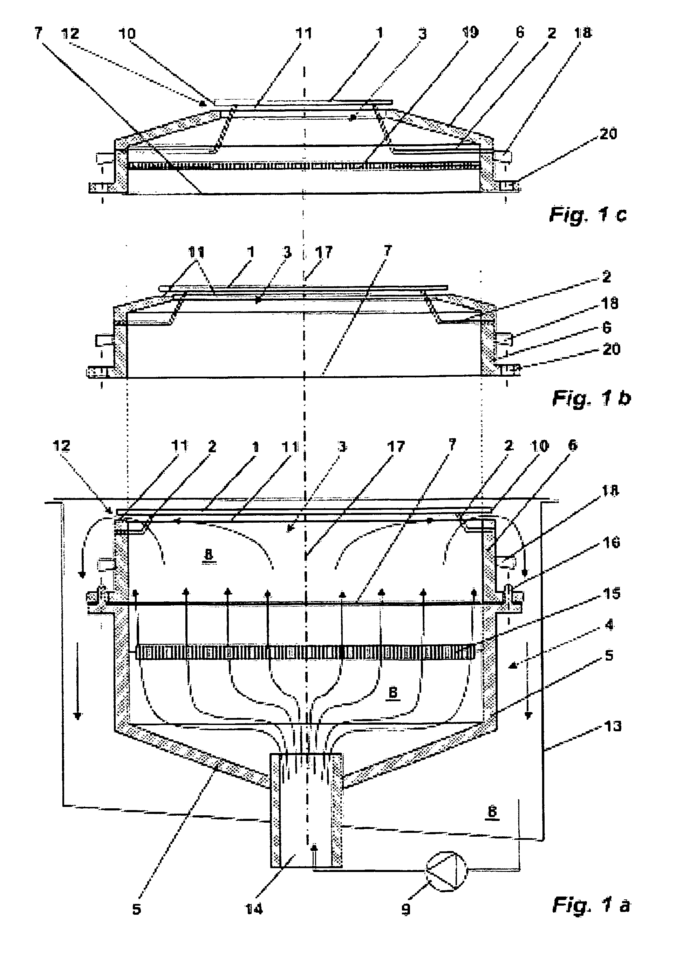

Die Erfindung wird nachfolgend an Hand der schematischen und nicht maßstäblichen Figuren 1 bis 3 detailliert beschrieben.
Figur 1 a zeigt im Querschnitt eine teilbare Prozesskammer, mit austauschbarem Oberteil, dessen Abmessungen für.das größte in der Anlage nass zu behandelnde Gut dimensioniert ist.
Figur 1 b zeigt ein austauschbares Oberteil, für ein zu produzierendes Gut, dessen Abmessungen kleiner sind, als das Gut in Figur 1 a.
Figur 1 c zeigt ein weiteres austauschbares Oberteil, für ein zu produzierendes Gut, dessen Abmessungen kleiner sind, als das Gut in Figur 1 b.
Figur 2 a zeigt im Querschnitt eine teilbare Prozesskammer, mit austauschbarem Oberteil, dessen Abmessungen für das größte in der Anlage mit löslichen Anoden zu galvanisierende Gut dimensioniert ist.

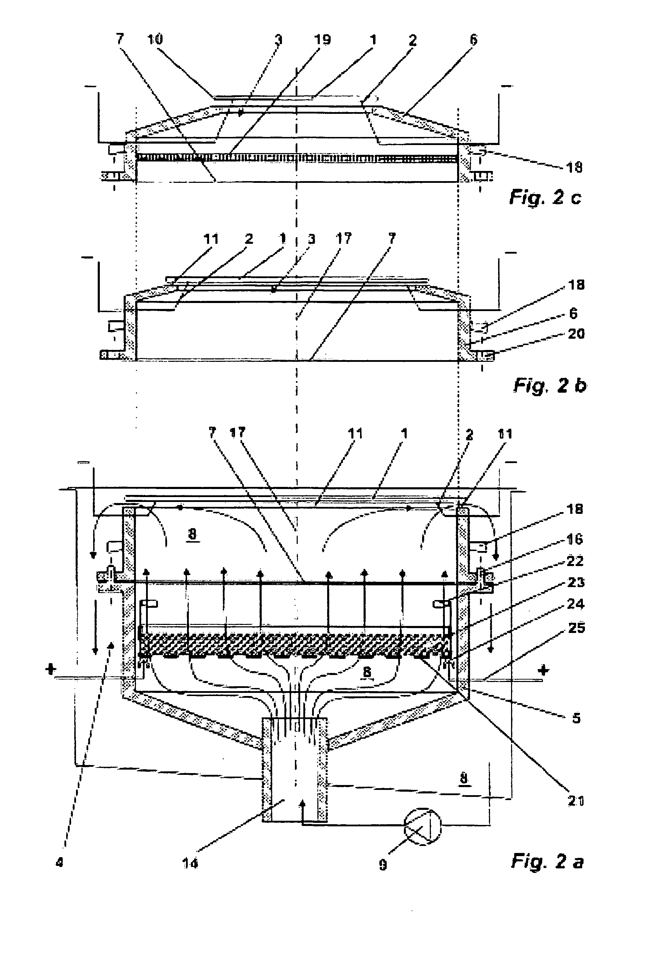

Figur 2 b zeigt ein austauschbares Oberteil, für ein zu produzierendes Gut, dessen Abmessungen kleiner sind, als das Gut in Figur 2 a.
Figur 2 c zeigt ein weiteres austauschbares Oberteil, für ein zu produzierendes Gut, dessen Abmessungen kleiner sind, als das Gut in Figur 2 b.

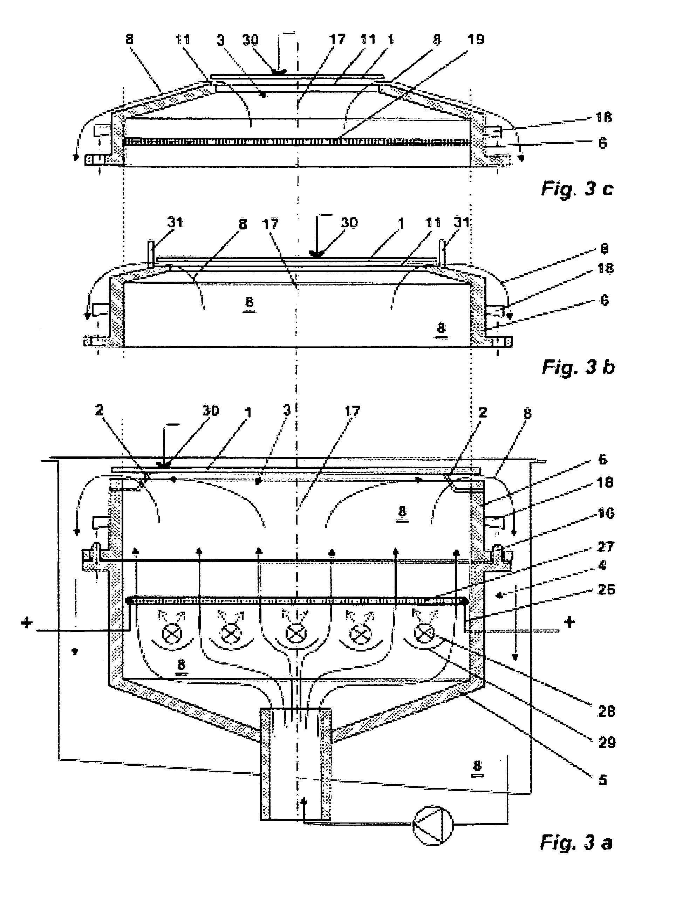

Figur 3 a zeigt im Querschnitt eine teilbare Prozesskammer mit Lichtquellen und austauschbarem Oberteil, dessen Abmessungen für die größte in der Produktionsanlage mit einer unlöslichen Anode zu galvanisierende Solarzelle dimensioniert ist.
Figur 3 b zeigt ein austauschbares Oberteil, für ein zu produzierendes Gut als Solarzelle, dessen Abmessungen kleiner sind, als das Gut in Figur 3 a.
Figur 3 c zeigt ein weiteres austauschbares Oberteil, für ein zu produzierendes Gut als Solarzelle, dessen Abmessungen kleiner sind, als das Gut in Figur 3 b.

In **Figur 1a** liegt das Gut 1 auf Gutauflagen 2 zentrisch im Bereich der oberen Öffnung 3 der erfindungsgemäßen Prozesskammer 4. Es kann auch ohne Gutauflagen 2 schwimmend auf der aus der Prozesskammer 4 ausströmenden Behandlungsflüssigkeit 8 zentriert liegen. Mit oder ohne Gutauflagen 2 können bei Bedarf zur Vermeidung eines seitlichen Wegschwimmens des Gutes 1 zusätzliche, hier nicht dargestellte seitliche Begrenzer angeordnet werden. Die Form der oberen Öffnung 3 des Oberteiles 6 ist kongruent mit der Form des zu behandelnden Gutes 1. Bei z. B. einem kreisrunden Gut 1 können die Abmessungen, d. h. der Durchmesser von Gut 1 und die obere Öffnung 3, geringfügig unterschiedlich groß sein. Die Differenz dieser Abmessungen ist abhängig von der jeweils erforderlichen Intensität der Nassbehandlung des Randbereiches des Gutes 1. Insbesondere wenn die Oberseite des Gutes von der Behandlungsflüssigkeit 8 nicht benetzt werden soll, wird die Abmessung der oberen Öffnung 3 kleiner gewählt, als die des Gutes. Diese Situation zeigen die Figuren 1 bis 3 als mögliche Beispiele der erfindungsgemäßen Ausführung der Prozesskammern 4.

Die Prozesskammer 4 besteht aus einem Unterteil 5 und dem jeweiligen Oberteil 6. Beide Teile 5, 6 sind trennbar miteinander verbunden. Die Trennstelle 7 ist am Unterteil 5 und am Oberteil 6 derart formschlüssig zueinander passend gestaltet, dass die Behandlungsflüssigkeit 8, die sich in der Prozesskammer 4 befindet, nicht oder nur geringfügig durch Leckagen hindurch an dieser Stelle aus der Prozesskammer 4 ausströmt. Die im Kreislauf mittels mindestens einer Pumpe 9 geförderte und die Prozesskammer 4 durchströmende Behandlungsflüssigkeit 8 gelangt an die zu behandelnde Unterseite und/oder an den Rand 10 des Gutes 1 und von dort über eine Überlaufkante 11, die einen Spalt 12 mit dem Gut 1 bildet, aus der Prozesskammer 4 heraus. Die ausströmende Behandlungsflüssigkeit 8 gelangt in einen Auffangbehälter 13 aus dem die Pumpe 9 diese durch mindestens ein Einlassrohr 14 wieder in die Prozesskammer 4 fördert. Das Unterteil 5 ist zusammen mit dem Auffangbehälter 13 und weiteren Aggregaten fest in der Produktionsanlage installiert.

Besonders im Unterteil 5 werden weitere zur Nassbehandlung erforderliche Betriebsmittel angeordnet. Dies können z. B. Anoden, Filter, Blenden, Lichtquellen, Reflektoren, Streuscheiben u. a. sein. In der Figur 1 a befindet sich im Unterteil 5 als Beispiel ein Strömungsmittel 15. Es beeinflusst den zur Behandlung des Gutes 1 an dessen Unterseite erforderlichen Austausch der Behandlungsflüssigkeit 8 zusammen mit der von der Pumpe 9 bestimmten Durchflussmenge derart, dass eine erforderliche gleichmäßige Behandlung des Gutes erfolgt. Vorteilhaft ist es, wenn die Durchflussmenge für die verschiedenen zu behandelnden Güter einstellbar ist, z. B. mittels Frequenzumrichter für den Pumpenantrieb. Die Prozesskammer 4 in der Figur 1 a ist für das größte in der Produktionsanlage zu produzierende Gut dimensioniert. Entsprechend groß ist die obere Öffnung 3 des Oberteils 6 und die Lage der Gutauflagen 2. Das vom Unterteil 5 trennbare Oberteil 6 wird z. B. mittels Zentrierstiften 16 und Zentrierbohrungen 20 oder einer anderen Zentrierung, z. B. einer Nut- und Federzentrierung so auf das Unterteil 5 aufgesetzt, dass ihre Mittenachsen 17 weitgehend oder völlig übereinstimmen.

Das Oberteil 6 dient zur Anpassung der Prozesskammer 4 an die Abmessungen und/oder an die zu behandelnden Strukturen an der Unterseite des Gutes. Bei einem Produktwechsel mit einem anderen Nennmaß bzw. anderen Abmessungen oder Strukturen des Gutes wird erfindungsgemäß das Oberteil 6 ausgetauscht. Dies kann manuell erfolgen. In einer großen automatisierten Produktionsanlage mit vielen Prozesskammern 4 muss dieser Austausch automatisch und in möglichst kurzer Zeit erfolgen. Hierzu befinden sich an allen Betriebsmitteln, die in der Anlage auszutauschen sind, individuelle Greifstellen bzw. Griffe, an denen von Transportmitteln als Handhabungsgeräte oder Roboterarme getragene Greifer das jeweilige Teil der Prozesskammer 4 und/oder Betriebsmittel ergreifen können. In Figur 1 a ist das Oberteil 6 bei Bedarf auszutauschen. Daher hat es mindestens einen hier dargestellten exponierten Behältergriff 18. Dieser oder diese sind entsprechend der Ausführung und Funktion des automatisierten Greifers gestaltet. Auch Einbuchtungen am Oberteil 6 können als Griffstellen für entsprechend gestaltete Greifer dienen.

Die mechanische Verbindung und Abdichtung von Unterteil 5 und Oberteil 6 ist so gestaltet, dass ein automatisches, bevorzugt vertikales Trennen, Abtransportieren und neu Aufsetzen eines anderen Oberteiles 6 möglich ist. Geeignet sind z. B. nicht dargestellte federnde Rasten, die mindestens die betriebsmäßig geringe erforderliche Kraft aufbringen, um während der Behandlung des Gutes beide Teile zusammen zu halten. Zum Trennen mittels des Greifers wird die Kraft der Rasten überwunden. Weil sich die Prozesskammer 4 im Auffangbehälter 13 befindet, ist eine geringfügige Leckage an der Trennstelle 7 bedeutungslos. Auch aus diesem Grunde ist eine sehr feste Verbindung von Oberteil 6 und Unterteil 5 nicht erforderlich.

Die **Figur 1b** zeigt ein weiteres Oberteil 6 mit den selben Abmessungen an der Trennstelle 7, wie sie das Unterteil 5 an dieser Trennstelle 7 hat. Die Zentrierbohrungen 20 des Oberteiles 6 passen auf die Zentrierstifte 16 des fest installierten Unterteiles 5. Bei einem Produktwechsel wird das dafür passende Oberteil 6 auf das Unterteil 5 bevorzugt automatisch aufgesetzt. Zuvor wurde das nicht passende Oberteil 6 ebenfalls bevorzugt automatisch vom Unterteil abgehoben und entfernt. Diese Austauschbarkeit des Oberteiles 6 erlaubt eine optimale konstruktive Anpassung an die Erfordernisse des jeweiligen zu produzierenden Gutes. Hierzu gehört auch eine bedarfsgerechte axiale Länge dieses Oberteiles. Insbesondere wenn im Oberteil Betriebsmittel erforderlich sind, kann es axial länger ausgeführt werden, als für andere in der Anlage zu produzierende Güter mit Oberteilen, die keine Betriebsmittel erfordern.

Das Gut 1 in Figur 1 b hat eine kleinere Abmessungen als das in Figur 1 a. Zugleich kann es bei gleich großem Nennmaß auch an der Unterseite wieder ein anderes Layout mit anders angeordneten Stellen zum Auflegen auf die Gutauflagen aufweisen. Die obere Öffnung 3 und die mechanische Ausführung und örtliche Anordnung der Gutauflagen 2, die Gestaltung der Überlaufkante 11 und die Größe des Spaltes 12 und weitere konstruktive Maßnahmen werden bei jedem Typ von Oberteil optimal an die Erfordernisse des jeweils damit zu produzierenden Gutes angepasst. Ein weiteres Beispiel hierfür zeigt die **Figur 1c**. Dargestellt ist ein vergleichsweise kleines zu behandelndes Gut. Zur Optimierung der hydrodynamischen Bedingungen an der Unterseite des Gutes 1 ist im Oberteil 6 als Beispiel ein Strömungsbegrenzer 19 angeordnet. Dieser sorgt zusammen mit der steuerbaren Pumpe 9 für die individuell erforderliche Strömung am Gut 1. Grundsätzlich können im Oberteil 6 weitere Betriebsmittel wie z. B. Anoden, Filter, Streuscheiben, Lichtquellen, Blenden, Reflektoren u. a. angeordnet werden. Aus wirtschaftlichen Gründen wird jedoch angestrebt, diese Betriebsmittel im jeweils pro Anlagenposition nur einmal vorkommenden Unterteil 5 anzuordnen. Für ein derart vollständig ausgerüstetes Unterteil 5 können dann an der Produktionsanlage verschiedene kostengünstige Oberteile 6 jeweils entsprechend der Anzahl der verschiedenen zu produzierenden Güter bevorratet werden. Diese Oberteile 6 werden nur dann mit zusätzlichen Betriebsmitteln ausgerüstet, wenn sie aus technologischen Gründen im Unterteil 5 nicht angeordnet werden können, so wie es die Figur 1 c zeigt. Ein derartiger im Unterteil 5 angeordneter Strömungsbegrenzer 19 würde die Behandlung von größeren Gütern, wie sie die Figuren 1 a und 1 b zeigen, behindern.

Die **Figur 2a** zeigt eine Prozesskammer 4 zur elektrolytischen Behandlung von Gut z. B. als Solarzelle. Hierzu befindet sich bevorzugt im Unterteil 5 ein Anodenkorb 21, z. B. bestehend aus Titanstreckmetall, der mit einer Anodenfüllung 23 als lösliche Anode gefüllt ist. Beim Galvanisieren werden diese löslichen Anoden langsam aufgelöst. Sie müssen von Zeit zu Zeit ergänzt und die Anodenkörbe 21 müssen gereinigt werden, d. h. es ist eine regelmäßige Wartungsarbeit erforderlich. Zur Vermeidung einer manuellen Wartung in der Produktionsanlage werden auch die Anodenkörbe 21 erfindungsgemäß automatisch aus dem Unterteil 5 herausgeholt. Dies erfolgt bevorzugt durch das oder durch die Transportmittel als Handhabungsgeräte oder Roboterarme mit daran befestigten Greifern. Diese befördern es zu einer Anodenwartungsstation. Die dort mit Anodenmaterial ergänzten und gereinigten Anodenkörbe 21 werden dann bevorzugt automatisch wieder in die Unterteile 5 der jeweiligen Anlagenpositionen zurück befördert. Damit dieser automatische Austausch möglich ist, muss der vertikale Weg des Anodenkorbes 21 aus der Prozesskammer 4 heraus frei sein. Nur wenn keine Gutauflagen 2 verwendet werden, ist dies der Fall. Daher wird bei vorhandenen Gutauflagen 2 für den Aus- und Einbau des Anodenkorbes 21 zunächst das Oberteil 6 bevorzugt automatisch abgehoben und entfernt. Dann erfolgt das Ausheben und der automatische Transport des Anodenkorbes 21. Hierzu befinden sich an dem Anodenkorb 21 mindestens zwei Anodengriffe 22 die von einem entsprechenden Greifer eines Handhabungsgerätes oder Roboterarmes gegriffen und mit dem Anodenkorb gehoben und transportiert werden.

Beim Ausheben des Anodenkorbes 21 öffnet sich selbsttätig der mindestens eine Anodenkontakt 24, der in die Anodenauflage(n) 25 eingreift, die den gesamten Anodenkorb 21 trägt oder tragen. Diese Anodenauflage 25 dient zugleich als anodische Stromzuführung von einem nicht dargestellten Gleichrichter zur Anode. Die Gutauflagen 2 im Oberteil 6 dienen beim Galvanisierprozess als kathodische Stromzuführung.

Bevorzugt unterhalb des Anodenkorbes 21 oder mit diesem gemeinsam aushebbar, können weitere Betriebsmittel im Unterteil 5 angeordnet werden.

Die **Figur 2b** zeigt ein individuelles Oberteil 6 für ein Gut 1 mit einem kleineren Nennmaß wie das in Figur 2 a dargestellte Gut 1. Auch hier dienen die Gutauflagen 2 als kathodische Stromzuführung zum Gut 1. Die **Figur 2c** zeigt ein weiteres individuelles Oberteil 6 für noch kleineres Gut 1, das galvanisiert werden soll. Zur hydrodynamischen Anpassung der Behandlungsflüssigkeit 8, d. h. zur Beeinflussung der Schichtdickenverteilung am Gut 1 ist ein Strömungsbegrenzer 19, bestehend aus deinem elektrische nicht leitenden Werkstoff eingebaut. Dieser Strömungsbegrenzer 19 kann zugleich als Blende zur Reduzierung der ansonsten intensiven Galvanisierung des Randbereiches des Gutes 1 dienen. An Stelle der dargestellten löslichen Anode kann auch eine unlösliche Anode verwendet werden.

Die **Figur 3a** zeigt eine Prozesskammer 4 zum Galvanisieren von Solarzellen. Als Beispiel ist hier im Unterteil 5 eine unlösliche Anode 27 eingebaut. Sie wird vom Anodenanschluss 26 gehalten und getragen. Weil diese unlösliche Anode 27 betriebsmäßig nicht gewartet werden muss, kann sie in der Prozesskammer 4 fest eingebaut sein. Sie besteht z. B. aus einem beschichteten Streckmetall, das wegen seiner vielen Öffnungen lichtdurchlässig ist. Dies wird in diesem Beispiel zur Beleuchtung der zu galvanisierenden Seite, nämlich der Sonnenseite der Solarzelle 1 genutzt. In diesem Falle kann die zum Galvanisieren erforderliche elektrische Stromzuführung zur Solarzelle 1 wegen dessen Niederohmigkeit mittels mindestens eines Kontaktes 30 von der Oberseite erfolgen. Die Solarzelle 1 liegt hier bevorzugt auf elektrisch nichtleitenden Gutauflagen 2.

Die mindestens eine Lichtquelle 28 ist in dem Beispiel der Figuren 3 unterhalb der unlöslichen Anode 27 angeordnet. Lichtreflektoren 29 lenken das Licht in Richtung zur Solarzelle 1, die durch die Beleuchtung von der Unterseite als Sonnenseite zur Oberseite elektrisch niederohmig ist. Dies erlaubt die vorteilhafte elektrische Kontaktierung von der Oberseite des Gutes 1, wie es in den Figuren 3 dargestellt ist. In diesem Falle werden die Kontakte 30, die sich außerhalb der Behandlungsflüssigkeit befinden, nicht metallisiert. Somit kann eine ansonsten erforderliche Entmetallisierung der Kontakte 30 entfallen.

Die Lichtquellen und Lichtreflektoren können im Elektrolyten auch oberhalb der Anode im Randbereich der entsprechend ausgebildeten Prozesskammer angeordnet werden. Dies erlaubt auch die Verwendung von löslichen Anoden, wie z. B. Anodenplatten.

Insbesondere bei Verwendung von löslichen Anoden, die nicht lichtdurchlässig sind, kann das Einleiten von Licht zum Gut von außen durch mindestens eine transparente Wand der Prozesskammer bevorzugt oberhalb der Anode erfolgen. In diesem Falle befinden sich die Lichtquellen und Lichtreflektoren mindestens an einer Seite außerhalb der Prozesskammer vor der mindestens partiell transparenten Wand. Dort sind sie nicht dem in der Regel aggressiven Elektrolyten des elektrolytischen Bades ausgesetzt, wodurch entsprechende Schutzmaßnahmen entfallen können. Als transparenter Werkstoff für die Prozesskammer eignet sich z. B. Glas oder Kunststoff. Als Lichtquellen eignen sich in allen Ausführungen z. B. Glühlampen, Halogenlampen, Leuchtstofflampen oder Leuchtdioden.

Besonders vorteilhaft ist es, wenn das Gut 1 auf der aus der oberen Öffnung 3 der Prozesskammer 4 ausströmenden Behandlungsflüssigkeit 8 zentriert und stabil schwimmt, wie es die Figuren 3 b und besonders 3 c zeigen. Damit wird der Ort der Gutauflagen und die elektrische Kontaktierung völlig unabhängig vom Layout der zu galvanisierenden Solarzelle 1. Diese stabile Lage kann das Gut 1 mit oder ohne seitliche Begrenzer 31 einnehmen. Dies zeigen die **Figuren 3b und 3c**. Dargestellt sind wieder Oberteile 6 für kleineres Gut im Vergleich zur Figur 3 a jeweils mit oder ohne unterschiedliche Layouts an der Behandlungsseite. In Figur 3 b wird das auf der Behandlungsflüssigkeit 8 schwimmende Gut 1 gegen ein mögliches seitliches Verschieben durch Begrenzer 31 gesichert, die z. B. einen runden Querschnitt aufweisen.

Die Figur 3 c zeigt ein Beispiel aus der Praxis, bei der allein durch die symmetrischen hydrodynamischen Bedingungen der aus der oberen Öffnung 3 ausströmenden Behandlungsflüssigkeit 8 das Gut ohne Begrenzer selbstzentrierend über der oberen Öffnung 3 stabil schwimmt. Dies erlaubt auch die dargestellte elektrische Kontaktierung mittels des Kontaktes 30 von der trockenen Oberseite der Solarzelle 1, wenn die Sonnenseite beleuchtet wird. Die Unterseite wird sehr vorteilhaft mechanisch berührungslos nass behandelt, d. h. in diesem Beispiel galvanisiert.

Bei relativ kleinem Gut 1 kann bzw. können zusätzlich ein Strömungsbegrenzer 19 und/oder Blenden im Oberteil 6 vorteilhaft sein, so wie es die Figur 3 c zeigt.

### Bezugszeichenliste

- 1: Gut, Substrat, Wafer, Solarzelle
- 2: Gutauflage
- 3: obere Öffnung
- 4: Prozesskammer
- 5: Unterteil
- 6: Oberteil
- 7: Trennstelle
- 8: Behandlungsflüssigkeit, Elektrolyt
- 9: Pumpe
- 10: Rand des Gutes
- 11: Überlaufkante
- 12: Spalt
- 13: Auffangbehälter
- 14: Einlassrohr
- 15: Strömungsmittel
- 16: Zentrierstift
- 17: Mittenachse
- 18: Behältergriff
- 19: Strömungsbegrenzer
- 20: Zentrierbohrung
- 21: Anodenkorb
- 22: Anodengriff
- 23: Anodenfüllung, lösliche Anode
- 24: Anodenkontakt
- 25: Anodenauflage
- 26: Anodenanschluss
- 27: unlösliche Anode
- 28: Lichtquelle
- 29: Lichtreflektor
- 30: Kontakt
- 31: Begrenzer

## Patentansprüche

1. Vorrichtung zur Nassbehandlung einer Seite und/oder des Randes von flachen Gütern (1) unterschiedlicher Nennmaße mit einer modularen, mindestens zweigeteilten und an mindestens einer Trennstelle (7) trennbaren Prozesskammer (4), die aus einem Unterteil (5) und einem hierzu an der Trennstelle (7) formschlüssig passenden und auswechselbaren Oberteil (6) mit einer oberen, an das Nennmaß eines zu behandelnden Gutes (1) angepassten Öffnung (3) besteht, wobei das Modul des Oberteils (6) entsprechend dem Nennmaß des zu behandelnden Gutes (1) aus einer Gruppe ausgewählt ist, die aus unterschiedlichen Oberteilen (6) mit einer jeweils an ein mögliches Nennmaß eines Gutes (1) angepassten oberen Öffnung (3) besteht.

2. Vorrichtung nach Patentanspruch 1, **gekennzeichnet durch** eine formschlüssige, mittels Rasten einrastende Verbindung oder mittels einer Nut- und Federverbindung von Unterteil (5) und Oberteil (6), die automatisch von einem Greifer geschlossen und geöffnet werden kann.

3. Vorrichtung nach Patentanspruch 1 oder 2, **gekennzeichnet durch** eine radiale Ausrichtung des Oberteiles (6) auf dem Unterteil (5) **durch** Zentrierstifte (16) und Zentrierbohrungen (20) oder **durch** einen konstruktiven Formschluss.

4. Vorrichtung nach einem der Ansprüche 1 bis 3, **gekennzeichnet durch** individuell im Oberteil (6) und Unterteil (5) der Prozesskammer (4) angeordnete Betriebsmittel (15, 19, 21, 28, 29) zur optimalen Einstellung der erforderlichen Prozessbedingungen, wobei die Betriebsmittel (15, 19, 21) Greifer und hierzu passende Griffstellen (18, 22) aufweisen.

5. Vorrichtung nach einem der Patentansprüche 1 bis 4, **gekennzeichnet durch** axial unterschiedlich lange Oberteile (6).

6. Vorrichtung nach einem der Patentansprüche 1 bis 5, **gekennzeichnet durch** mindestens eine Lichtquelle (28) mit oder ohne Reflektor (29) innerhalb der Prozesskammer (4), zur Beleuchtung der Sonnenseite der zu galvanisierenden Solarzelle (1).

7. Vorrichtung nach einem der Patentansprüche 1 bis 5, **gekennzeichnet durch** mindestens eine Lichtquelle mit oder ohne Reflektor, die außerhalb der mindestens im Bereich der Lichtquelle transparenten Prozesskammer (4) angeordnet ist oder sind, zur Beleuchtung der Sonnenseite der zu galvanisierenden Solarzelle (1).

8. Vorrichtung nach einem der Patentansprüche 1 bis 7, **gekennzeichnet durch** mindestens eine elektrische Kontaktierung (30) zum Galvanisieren von Gut (1) an der Oberseite desselben.

9. Verfahren zur Nassbehandlung einer Seite und/oder des Randes von flachen Gütern (1) unterschiedlicher Nennmaße durch Bereitstellung einer Vorrichtung mit einer modularen, mindestens zweigeteilten und an mindestens einer Trennstelle (7) trennbaren Prozesskammer (4), die aus einem Unterteil (5) und einem hierzu an der Trennstelle (7) formschlüssig passenden und auswechselbaren Oberteil (6) mit einer oberen, an das Nennmaß eines zu behandelnden Gutes (1) angepassten Öffnung (3) besteht, wobei das Oberteil (6) der Prozesskammer (4) entsprechend dem Nennmaß des zu behandelnden Gutes (1) aus einer Gruppe von unterschiedlichen Oberteilen (6) mit einer jeweils an ein mögliches Nennmaß eines Gutes (1) angepassten oberen Öffnung (3) ausgewählt und formschlüssig mit dem Unterteil (5) der Prozesskammer (4) verbunden wird, Positionierung des zu behandelnden Gutes (1) an der oberen Öffnung (3) des ausgewählten Oberteils (6), und Durchführung der Nassbehandlung.

10. Verfahren nach Patentanspruch 9, bei dem die aus der Gruppe unterschiedlicher Oberteile ausgewählten Oberteile (6) der Prozesskammer (4) mittels Transportmitteln als Handhabungsgeräte oder Roboterarme automatisch ausgetauscht werden.

11. Verfahren nach Patentanspruch 9 oder 10, bei dem das Gut (1) über der oberen Öffnung (3) schwimmend gelagert wird.

12. Verfahren nach Patentanspruch 9 oder 10, wobei die Vorrichtung im Bereich der oberen Öffnung (3) des Oberteils (6) Gutauflagen (2) aufweist, mit denen das Gut (1) gelagert und bei einer elektrolytischen Behandlung elektrisch kontaktiert wird.

13. Verfahren nach einem der Patentansprüche 9 bis 12, bei dem die Prozesskammer (4) einen Elektrolyten (8) enthält und das zu behandelnde Gut (1) eine Solarzelle ist, die durch Beleuchtung im Elektrolyten von ihrer Unterseite zur Oberseite elektrisch niederohmig wird.

14. Verfahren nach Patentanspruch 13, bei dem die Beleuchtung durch mindestens eine Lichtquelle erfolgt, die außerhalb einer mindestens partiell transparenten Prozesskammer (4) angeordnet ist.

15. Verfahren nach Patentanspruch 13 oder 14, bei dem die beleuchtete Solarzelle (1) an der Oberseite elektrisch kontaktiert wird.

## Claims

1. Apparatus for the wet processing of a side and/or the border of flat goods (1) of different nominal sizes by means of a modular, at least two-part process chamber (4) which can be separated at at least one disconnection point (7) and consists of a lower part (5) and an exchangeable upper part (6) that form-locking fits the lower part at the disconnection point (7), the upper part having an upper opening (3) which is adapted to the nominal size of a good (1) to be processed, wherein the module of the upper part (6) is, according to the nominal size of the good (1) to be processed, selected from a group consisting of different upper parts (6) each having an upper opening (3) being adapted to a possible nominal size of a good (1).

2. Apparatus according to claim 1, **characterized by** a form-locking connection of lower part (5) and upper part (6) which locks by means of notches or by means of a key and slot joint, and which can automatically be closed and opened by a gripper.

3. Apparatus according to claim 1 or 2, **characterized by** a radial orientation of the upper part (6) on the lower part (5) by means of centre pins (16) and centre holes (29), or by means of a constructive form fit.

4. Apparatus according to one of claims 1 to 3, **characterized by** operating equipment (15, 19, 21, 28, 29) for optimal adjustment of the required process conditions being individually arranged in the upper part (6) and the lower part (5) of the process chamber (4), wherein the operating equipment (15, 19, 21) provides grippers and gripping points (18, 22) suiting them.

5. Apparatus according to one of claims 1 to 4, **characterized by** upper parts (6) of different axial lengths.

6. Apparatus according to one of claims 1 to 5, **characterized by** at least one light source (28) with or without reflector (29) within the process chamber (4), for the illumination of the sun side of the solar cell (1) to be electroplated.

7. Apparatus according to one of claims 1 to 5, **characterized by** at least one light source with or without reflector being arranged outside of the process chamber (4) which is transparent at least in the region of the light source, for the illumination of the sun side of the solar cell (1) to be electroplated.

8. Apparatus according to one of claims 1 to 7, **characterized by** at least one electrical contacting (30) for the electroplating of good (1) at the upper side of the same.

9. Method for the wet processing of a side and/or the border of flat goods (1) of different nominal sizes by provision of an apparatus with a modular, at least two-part process chamber (4) which can be separated at at least one disconnection point (7) and consists of a lower part (5) and an exchangeable upper part (6) that form-locking fits the lower part at the disconnection point (7), the upper part having an upper opening (3) which is adapted to the nominal size of a good (1) to be processed, wherein the upper part (6) of the process chamber (4) is, according to the nominal size of the good (1) to be processed, selected from a group consisting of different upper parts (6) each having an upper opening (3) being adapted to a possible nominal size of a good (1), and in a form-locking manner connected with the lower part (5) of the process chamber (4), positioning of the good (1) to be processed at the upper opening (3) of the selected upper part (6), and performing the wet processing.

10. Method according to claim 9, wherein the process chamber's (4) upper parts (6) being selected from the group of different upper parts are automatically exchanged by means of transport means as handling devices or robotic arms.

11. Method according to claim 9 or 10, wherein the good (1) is floatingly supported above the upper opening (3).

12. Method according to claim 9 or 10, wherein the apparatus in the region of the upper opening (3) of the upper part (6) provides good supports (2), by means of which the good (1) is supported and, during an electrolytic treatment, electrically contacted.

13. Method according to one of claims 9 to 12, wherein the process chamber (4) contains an electrolyte (8), and wherein the good (1) to be processed is a solar cell which, upon illumination in the electrolyte, becomes electrically low-resistance from its underside to its upper side.

14. Method according to claim 13, wherein the illumination takes place by means of at least one light source which is arranged outside of an at least partially transparent process chamber (4).

15. Method according to claim 13 or 14, wherein the illuminated solar cell (1) is electrically contacted at the upper side.

## Revendications

1. Dispositif pour le traitement humide d'un coté et/ou du bord de biens plats (1) de cotes nominales différentes avec une chambre de traitement (4) modulaire, au moins en deux parties et dissociable au niveau de au moins une séparation (7), qui consiste en une partie inférieure (5) et une partie supérieure (6) interchangeable et à la forme ajustée à la séparation (7) avec une ouverture supérieure (3) adaptée à la cote nominale du bien à traiter (1), le module de la partie supérieure (6) étant sélectionné selon la cote nominale du bien à traiter (1) dans un groupe constitué de différentes parties supérieures (6) ayant chacune une ouverture supérieure (3) adaptée à une cote nominale possible d'un bien (1).

2. Dispositif selon la revendication 1, **caractérisé par** une fermeture solidaire par l'intermédiaire d'encoches ou par un assemblage de tenon et mortaise de la partie inférieure (5) et de la partie supérieure (6), qui peut être automatiquement fermée et ouverte par un préhenseur.

3. Dispositif selon la revendication 1 ou la revendication 2, **caractérisé par** une orientation radiale de la partie supérieure (6) sur la partie inférieure (5) par l'intermédiaire de pointes (16) et trous (20) de centrage, ou par une fermeture ajustée à la construction.

4. Dispositif selon une des revendications 1 à 3, **caractérisé par** des équipements (15, 19, 21, 28, 29) individuels localisés dans la partie supérieure (6) et la partie inférieure (5) de la chambre de traitement (4) pour un réglage optimal des conditions de traitement requises, les équipements (15, 19, 21) comprenant préhenseurs et les points de préhension adaptés (18, 22).

5. Dispositif selon une des revendications 1 à 4, **caractérisé par** des parties supérieures (6) de différentes longueurs axiales.

6. Dispositif selon une des revendications 1 à 5, **caractérisé par** au moins une source de lumière (28) avec ou sans réflecteur (29) à l'intérieur de la chambre de traitement (4), pour l'illumination du coté exposé au soleil de la cellule photovoltaïque (1) à galvaniser.

7. Dispositif selon une des revendications 1 à 5, **caractérisé par** au moins une source de lumière avec ou sans réflecteur qui est ou sont localisée(s) à l'extérieur de la chambre de traitement (4) transparente au moins au niveau de la source de lumière, pour l'illumination du coté exposé au soleil de la cellule photovoltaïque (1) à galvaniser.

8. Dispositif selon une des revendications 1 à 7, **caractérisé par** au moins un contact électrique (30) pour la galvanisation du bien (1) à sa surface supérieure.

9. Méthode pour le traitement humide d'un coté et/ou du bord de biens plats (1) de cotes nominales différentes par la mise à disposition d'une chambre de traitement (4) modulaire, au moins en deux parties et dissociable au niveau de au moins une séparation (7), qui consiste en une partie inférieure (5) et une partie supérieure (6) interchangeable et à la forme ajustée à la séparation (7) avec une ouverture supérieure (3) adaptée à la cote nominale du bien à traiter (1), la partie supérieure (6) de la chambre de traitement (4) étant sélectionnée selon la cote nominale du bien à traiter (1) dans un groupe constitué de différentes parties supérieures (6) ayant chacune une ouverture supérieure (3) adaptée à une cote nominale possible d'un bien (1) et reliée par une liaison ajustée à la partie inférieure (5) de la chambre de traitement (4), positionnement du bien à traiter (1) à l'ouverture supérieure (3) de la partie supérieure (6) choisie, et mise en oeuvre du traitement.

10. Méthode selon la revendication 9, dans laquelle les parties supérieures (6) de la chambre de traitement (4), choisies dans le groupe constitué de différentes parties supérieures, sont changées automatiquement par des moyens de transport tels que des manipulateurs ou des bras robotiques.

11. Méthode selon la revendication 9 ou la revendication 10, dans laquelle le bien (1) est déposé flottant au dessus de l'ouverture supérieure (3).

12. Méthode selon la revendication 9 ou la revendication 10, dans laquelle le dispositif présente dans la région de l'ouverture supérieure (3) de la partie supérieure (6) des embases (2) pour les biens avec lesquelles le bien (1) est déposé et est mis au contact électrique au cours d'un traitement électrolytique.

13. Méthode selon une des revendications 9 à 12, dans laquelle la chambre de traitement (4) contient un électrolyte (8), et le bien (1) à traiter est une cellule photovoltaïque qui devient à faible impédance électrique par illumination dans l'électrolyte de sa face inférieure à sa face supérieure.

14. Méthode selon la revendication 13, dans laquelle l'illumination se produit par au moins une source lumineuse qui est localisée à l'extérieur d'une chambre de traitement (4) au moins partiellement transparente.

15. Méthode selon la revendication 13 ou la revendication 14, dans laquelle la cellule photovoltaïque illuminée (1) est mise au contact électrique sur la face supérieure.
